**Europäisches Patentamt**

**European Patent Office**

**Office européen des brevets**

(11) Veröffentlichungsnummer: **0 164 132**
A2

# EUROPÄISCHE PATENTANMELDUNG

Anmeldenummer: **85107073.0**

Anmeldetag: **07.06.85**

(51) Int. Cl.⁴: **C 23 C 14/24**

Priorität: **08.06.84 DE 3421538**

Veröffentlichungstag der Anmeldung: **11.12.85**
**Patentblatt 85/50**

Benannte Vertragsstaaten: **DE FR GB**

(71) Anmelder: **ATOMIKA Technische Physik GmbH,
Kuglmüllerstrasse 6, D-8000 München 19 (DE)**

(72) Erfinder: **Mertens, Horst M., Dipl.-Phys.,
Radolfzellerstrasse 9a, D-8000 München 60 (DE)**
Erfinder: **Bögl, Leonhard, Dipl.-Ing. (FH), Bergstrasse 9,
D-8253 Buchbach (DE)**

(74) Vertreter: **Heusler, Wolfgang, Dipl.-Ing. et al, Von Bezold,
Dieter, Dr. Schütz, Peter, Dipl.-Ing. Heusler, Wolfgang,
Dipl.-Ing. Maria-Theresia-Strasse 22 Postfach 860 260,
D-8000 München 86 (DE)**

(54) **Vakuumaufdampfeinrichtung.**

㊡ Bei der vorliegenden Vakuumaufdampfeinrichtung ist die Substrathalterung (36) stationär im Hauptteil der Aufdampfkammer angeordnet. Die Verdampfervorrichtungen (42) sind am Boden (14) der Aufdampfkammer angeordnet, der über einen Balgen (16) beweglich mit dem Hauptteil der Aufdampfkammer verbunden und durch zwei Antriebsvorrichtungen (60) bezüglich des Hauptteiles um zwei sich kreuzende Achsen schwenkbar oder längs zweier sich kreuzender Achsen verschiebbar ist. Hierdurch wird die Thermostatisierung des Substrats und die Herstellung sehr gleichmässiger Schichten erleichtert.

11594 Dr.v.B/Schä/23

ATOMIKA Technische Physik GmbH,
Kuglmüllerstrasse 6, 8000 München 19

Vakuumaufdampfeinrichtung

Die vorliegende Erfindung betrifft eine Vakuumaufdampfeinrichtung gemäß dem Oberbegriff des Patentanspruchs 1.
Insbesondere betrifft die Erfindung eine Aufdampfeinrichtung, die sich zur Herstellung epitaxialer Schichten
nach dem Molekularstrahlverfahren eignet.

Beim Aufdampfen dünner Schichten hoher Gleichmäßigkeit,
wie sie z.B. bei der Molekularstrahlepitaxie und auch
bei der Herstellung von Interferenzfiltern und dergl.
benötigt werden, sind Maßnahmen zum Ausgleich der
unvermeidbar örtlich unterschiedlichen Dichten des von
der oder den Aufdampfmaterialquellen ausgehenden Atom-
oder Molekülstrahlen notwendig. Bei den bekannten
Aufdampfeinrichtungen ist für diesen Zweck eine Substrathalterung vorgesehen, die eine einfache oder
komplexere Rotation des zu bedampfenden Substrats
gestattet, während die Verdampfer oder Aufdampf-Materialquellen in der Vakuumkammer stationär unterhalb der
Substrathalterung angeordnet sind. Die Aufdampfmaterialquellen, die z.B. aus sogenannten Knudsen-Zellen bestehen können, sind im allgemeinen jeweils mit einer
beweglichen Blende oder anderen Abschirmvorrichtung versehen, die zwischen die betreffende Quelle und das Substrat gebracht werden kann, um den von der betreffenden Quelle auf das Substrat gerichteten Strahl des verdampften Materials freizugeben.

Der Substrathalterung ist gewöhnlich eine Vorrichtung zur Thermostatisierung des Substrats zugeordnet. Nachteilig an den bekannten Vakuumaufdampfeinrichtungen ist es, daß die Vorrichtungen zur Bewegung des Substrats dem Ultrahochvakuum und Niederschlägen aus dem verdampften Material ausgesetzt sind, außerdem ist die Thermostatisierung der beweglichen Substrathalterung schwierig. Schließlich läßt auch oft die Gleichmäßigkeit des Niederschlages zu wünschen übrig.

Der vorliegenden Erfindung liegt dementsprechend die Aufgabe zugrunde, eine Vakuumaufdampfeinrichtung der eingangs genannten Art dahingehend weiterzuentwickeln, daß eine sehr hohe Gleichmäßigkeit der aufgedampften Schichten erreicht wird und die für die Vergleichmäßigung des Niederschlages erforderlichen Bewegungsvorrichtungen außerhalb des Vakuums angeordnet werden können.

Diese Aufgabe wird durch die im Patentanspruchs 1 gekennzeichnete Erfindung gelöst. Weiterbildungen und vorteilhafte Ausgestaltungen der erfindungsgemäßen Vakuumaufdampfeinrichtung sind Gegenstand von Unteransprüchen.

Da bei der Vakuumaufdampfeinrichtung gemäß der Erfindung keine komplizierten Bewegungen des Substrats erforderlich sind, um dünne Schichten hoher Gleichmäßigkeit herstellen zu können und das Substrat während des Bedampfens ruhen kann, läßt sich die Thermostatisierung sehr exakt durchführen und das kristalline Wachstum von aufgedampften Schichten kontinuierlich verfolgen. Ein weiterer Vorteil der vorliegenden Einrichtung besteht darin, daß mit einfachen Mitteln mehrere Freiheitsgrade der Bewegung der Verdampfervorrichtung bezüglich des Substrats und damit eine wesentlich höhere Gleichmäßigkeit der Bedampfung erreicht werden können.

Alle Antriebs- und Steuerelemente für die Verdampfereinrichtung können außerhalb der Aufdampfkammer angeordnet werden, was ihren Aufbau vereinfacht und ihre Zuverlässigkeit erhöht.

Im folgenden wird ein bevorzugtes Ausführungsbeispiel der Erfindung unter Bezugnahme auf die Zeichnungen näher erläutert.

Es zeigen:

Fig. 1 eine etwas schematisierte, geschnittene Seitenansicht einer Vakuumaufdampfeinrichtung gemäß der derzeit bevorzugten Ausführungsform der Erfindung;

Fig. 2 eine Teilansicht in einer Ebene II-II der Fig. 1, aus der Einzelheiten einer kardanischen Lagerung eines beweglichen Bodenteiles der Aufdampfkammer ersichtlich sind;

Fig. 3 eine in Richtung des Pfeiles III in Fig. 2 gesehene Seitenansicht und

Fig. 4 eine Fig. 3 entsprechende Ansicht einer Vorrichtung zum translatorischen Hin- und Herbewegen des Bodenteiles der Aufdampfkammer.

Die in den Zeichnungen dargestellte Vakuumaufdampfeinrichtung enthält eine Aufdampfkammer 10, deren Wand
einen im wesentlichen glockenförmigen, unten offenen
oberen Hauptteil 12 und einen platten- oder flanschartigen unteren Bodenteil 14 aufweist, die über eine
vakuumdichte Verbindungsvorrichtung, insbesondere einen
Balgen 16, vakuumdicht und relativ zueinander beweglich
miteinander verbunden sind.

Das untere Ende des Hauptteiles 12, an dem das eine Ende
des Balgens 16 angebracht ist, ist mit einer stationären
ringförmigen Basisplatte 18 verbunden, die einen Teil
eines sonst nicht weiter dargestellten stationären
Rahmens bildet, der die Vakuumaufdampfeinrichtung als
Ganzes haltert.

Der Hauptteil 12 weist in üblicher Weise mindestens
einen Anschlußstutzen 20 für eine Vakuumpumpe 22,
Anschlußstutzen 24, 26 für nur schematisch dargestellte
Ventile oder Schleusen 28 und einen oben in der Mitte
befindlichen Anschlußstutzen 30 für eine Substrathalterungsvorrichtung 32 auf. Die Substrathalterungsvorrichtung 32 enthält ein elektrisches Heizelement 34 für die
Thermostatisierung mindestens eines Substrats 36 sowie
einen Temperaturfühler 38 zur Messung der Substrattemperatur.

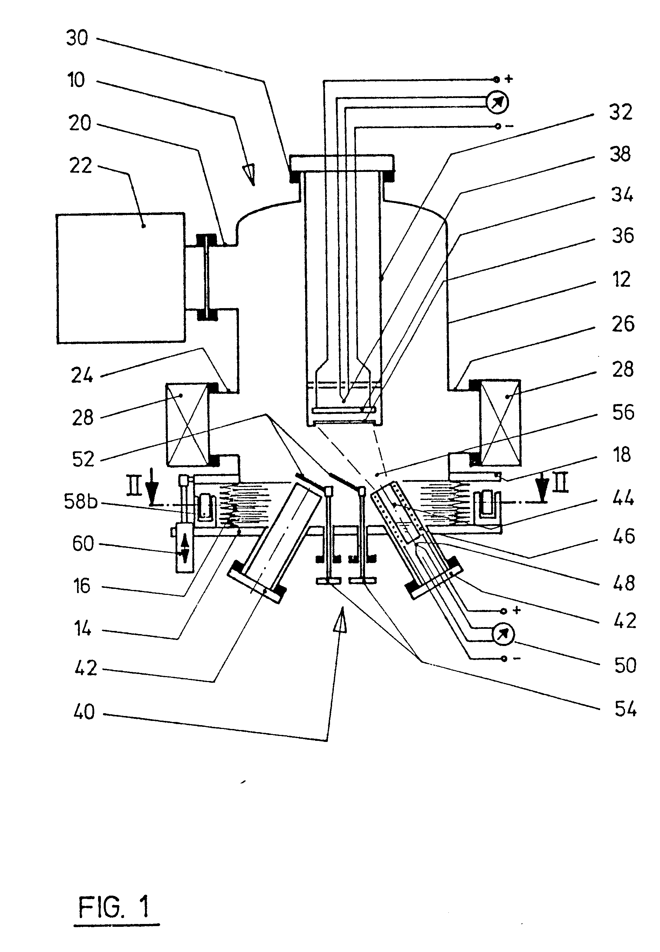

Am plattenförmigen Bodenteil 14 der Aufdampfkammer 10
ist eine als Ganzes mit 40 bezeichnete Verdampfervorrichtung angeordnet. Die Verdampfervorrichtung 14 kann
z.B. mehrere Aufdampfmaterialquellen in Form von Knudsen-Zellen 42 enthalten, welche ihrerseits jeweils eine
zum Inneren der Aufdampfkammer hin offene rohrförmige Verdampferkammer 44, eine diese umgebende Heizvorrichtung 46 in Form einer elektrischen Widerstandsheizwendel und einen Temperaturfühler 48, der mit einem Temperaturanzeigegerät 50 verbunden ist, enthalten können. Die Verdampfereinrichtung 40 enthält ferner für jede Aufdampfmaterialquelle eine Vorrichtung, die den auf das Substrat 34 gerichteten Strahl des von der betreffenden Quelle verdampften Materials freizugeben bzw. vom Substrat fernzuhalten gestattet. Diese Vorrichtungen können beispielsweise jeweils aus einer plattenförmigen Blende 52 bestehen, die durch eine von außen bedienbare Betätigungsvorrichtung 54 vor den Auslaß der betreffenden Aufdampfmaterialquelle geschwenkt werden kann, wie es bei der linken Zelle 42 dargestellt ist, oder aus dem Weg des aus der betreffenden Quelle austretenden Atom- oder Molekularstrahls 56 geschwenkt werden kann, wie es bei der rechten Zelle 42 in Fig. 1 dargestellt ist.

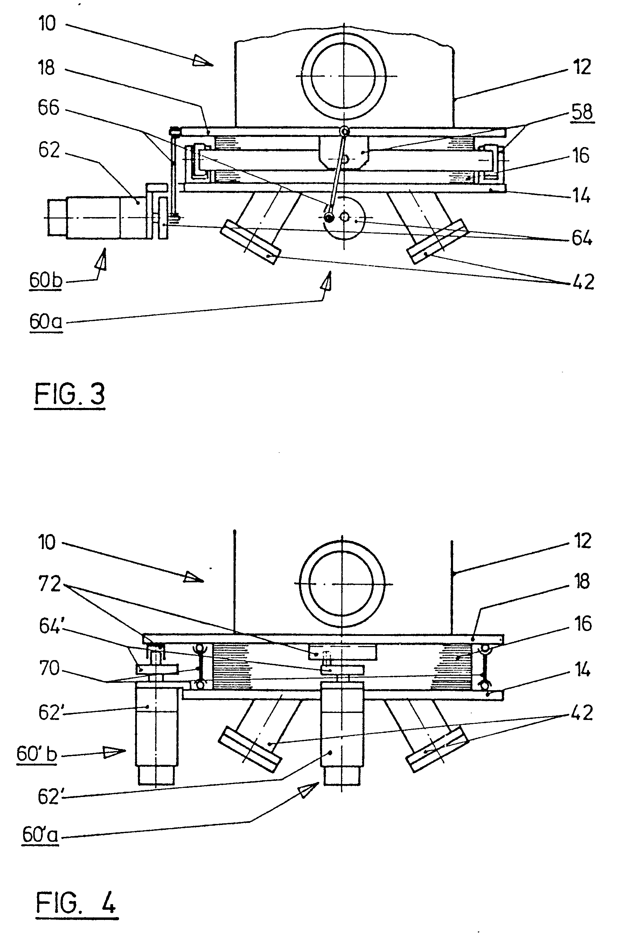

Gemäß der Erfindung ist der Bodenteil 14 bezüglich des durch die Basisplatte 18 stationär gelagerten Hauptteils 12 der Aufdampfkammer beweglich gelagert, und zwar vorzugsweise und vorteilhafterweise so, daß der Bodenteil 14 mit der Verdampfervorrichtung 40 eine Schwenkbewegung um zwei Achsen und dadurch eine Taumelbewegung ausführen kann. Gemäß einer ebenfalls vorteilhaften Alternative (oder zusätzlich) ist eine Vorrichtung zur translatorischen Verschiebung des Bodenteils bezüglich des Hauptteiles in mindestens einer Richtung vorgesehen, wie unter Bezugnahme auf Fig. 4 noch erläutert werden wird.

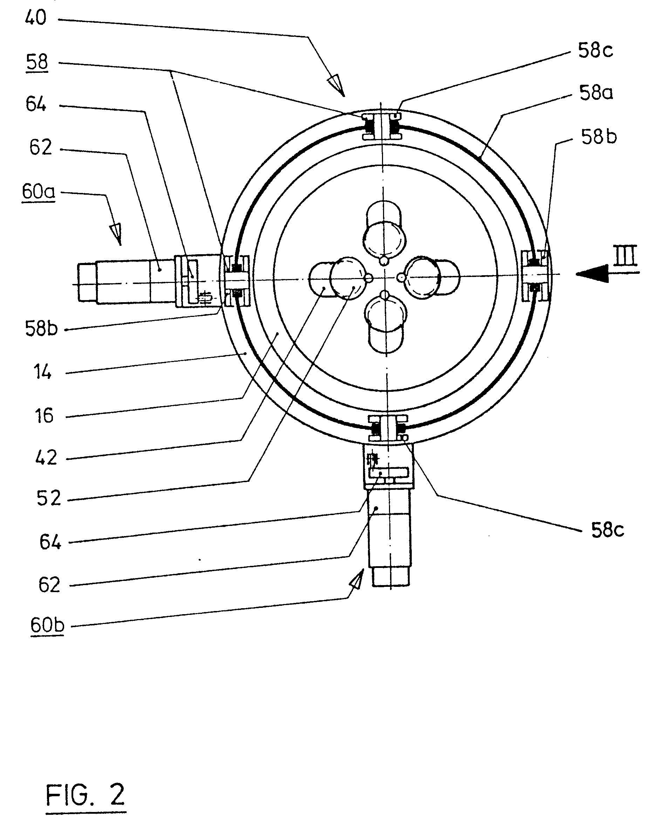

Um bei der Ausführungsform gemäß Fig. 1 bis 3 die Schwenk- und Taumelbewegungen der Verdampfervorrichtung 40 bezüglich der stationären Substrathalterung 52 zu ermöglichen, ist der Bodenteil 14 über eine in Fig. 2 genauer dargestellte kardanische Aufhängung 58 an der Basisplatte 18 gelagert. Die kardanische Aufhängung 58 enthält einen Ring 58a, der über ein Paar von Lagerböcken 58b mit dem Bodenteil 14 und über ein um 90° versetztes zweites Paar von Lagerböcken 58c mit der Basisplatte 18 schwenkbar verbunden ist. Ferner sind zwei in Umfangsrichtung gegeneinander z.B. um 90° versetzte Antriebsvorrichtungen 60a und 60b vorgesehen. Die Antriebsvorrichtungen sind mit dem im allgemeinen etwa kreisförmigen Bodenteil 14 und der Basisplatte 18 so verbunden , daß sie die Basisplatte jeweils um eine von zwei sich kreuzenden Achsen zu schwenken gestatten, die in zur Ebene der Basisplatte wenigstens annähernd parallelen Ebenen verlaufen. Die Antriebsvorrichtungen 60a und 60b, von denen in Fig. 1 nur eine Paar zu sehen ist, sind unabhängig voneinander steuerbar, so daß der Bodenteil 14 unabhängige oszillierende Schwenkbewegungen um die beiden Achsen ausführen kann und die Materialstrahlen 56 daher eine praktisch beliebige Schwenkbewegung, etwa nach Art von Lissajous'schen Figuren ausführen können.

Die Antriebsvorrichtungen 60 können beispielsweise Hydraulik- oder Pneumatikzylinder, Magnetspulen, mechanische Exzenter oder dergl. enthalten. Bevorzugt wird ein durch einen Elektromotor 62 mit veränderbarer Drehzahl angetriebener Exzenter 64, da sich hier die Oszillationsfrequenzen am einfachsten steuern lassen. Die Elektromotoren sind am Bodenteil 14 (oder an der Basisplatte 18) befestigt und der Exzenter 64 jedes Elektromotors 62 ist über eine Koppelstange 66 mit einem an der Basisplatte 18 (oder dem Bodenteil 14) angebrachten Lagerzapfen gelenkig verbunden. Die Drehzahl der Elektromotoren ist in bekannterweise unabhängig voneinander steuerbar, so daß der Bodenteil 14 mit den Aufdampfvorrichtungen bezüglich der Substrathaltevorrichtung 32 um zwei sich kreuzende Achsen schwenkbar ist.

Bei der in Fig. 4 dargestellten Ausführungsform ist der Bodenteil 14 bezüglich des Hauptteiles 12 der Wand der Vakuumkammer in zwei sich z.B. unter einem Winkel von 90° kreuzenden Richtungen translatorisch verschiebbar. Der Bodenteil 14 ist hierzu an der Basisplatte 18 durch drei oder mehr Pendelstützen 70 gelagert, deren Enden über Kugelpfannengelenke mit dem Bodenteil 14 bzw. der Basisplatte 18 verbunden sind, so daß der Bodenteil 14 im wesentlichen in seiner Ebene beliebig bezüglich des Hauptteiles 12 verschoben werden kann. Bei Fig. 4 erfolgt die Verschiebung in zwei zueinander im wesentlichen senkrechten Richtungen mittels zweier Elektromotoren 62', deren Drehzahl unabhängig voneinander steuerbar ist. Die Elektromotoren 62' treiben jeweils eine Exzenterscheibe 64' an, die einen exzentrischen Zapfen aufweist, der in einer tangential verlaufenden, an der Basisplatte angebrachten, U-förmigen Führung 72 läuft.

DR. DIETER v. BEZOLD
DIPL. ING. PETER SCHÜTZ
DIPL. ING. WOLFGANG HEUSLER
PATENTANWÄLTE
MARIA-THERESIA-STRASSE 22
POSTFACH 860260
D-8000 MUENCHEN 86

ZUGELASSEN BEIM
EUROPÄISCHEN PATENTAMT

EUROPEAN PATENT ATTORNEYS

MANDATAIRES EN BREVETS EUI

TELEFON (089) 4706006
TELEX 522638
TELEGRAMM SOMBEZ
FAX GR II + III (089) 271606:

0164132

—1—

11594 Dr.v.B/Schä/23

ATOMIKA Technische Physik GmbH,
Kuglmüllerstrasse 6, 8000 München 19

Vakuumaufdampfeinrichtung

Patentansprüche

1. Vakuumaufdampfeinrichtung mit einer vakuumdichten Aufdampfkammer (10), in der sich eine Subtrathalterungsvorrichtung (32) für mindestens ein zu bedampfendes Substrat, welche an einem ersten Teil (12) der Wand der Aufdampfkammer angebracht ist, und eine an einem zweiten Teil (14) der Wand der Aufdampfkammer angebrachte Verdampfervorrichtung (40) mit mindestens einer heizbaren Aufdampfmaterialquelle (42) angeordnet sind, dadurch gekennzeichnet, daß die beiden Teile (12, 14) der Wand derAufdampfkammer (10) über eine vakuumdichte Verbindungsvorrichtung (16), die eine Bewegung der beiden Teile (12, 14) in Bezug aufeinander zuläßt, miteinander verbunden sind und mit einer ihre Bewegung in Bezug aufeinander bewirkenden Antriebsvorrichtung (60) gekoppelt sind.

POSTSCHECK MÜNCHEN NR. 60148-800 · BANKKONTO HYPOBANK MÜNCHEN (BLZ 700200401 KTO. 6060257378 SWIFT HYPO D

2. Vakuumaufdampfeinrichtung nach Anspruch 1, **dadurch gekennzeichnet**, daß der zweite Teil (14) der Wand der Aufdampfkammer den Boden der Aufdampfkammer bildet.

3. Vakuumaufdampfeinrichtung nach Anspruch 1 oder 2, **dadurch gekennzeichnet**, daß die vakuumdichte Verbindungsvorrichtung (16) einen Balgen enthält.

4. Vakuumaufdampfeinrichtung nach Anspruch 1, 2 oder 3, **dadurch gekennzeichnet**, daß die beiden Teile (12, 14) der Wand der Aufdampfkammer in Bezug aufeinander schwenkbar gelagert sind.

5. Vakuumaufdampfeinrichtung nach Anspruch 4, **dadurch gekennzeichnet**, daß die beiden Teile (12, 14) der Wand der Aufdampfkammer durch eine kardanische Aufhängung in Bezug aufeinander beweglich gelagert und durch zwei Antriebsvorrichtungen (60a, 60b) um zwei sich kreuzende Achsen in Bezug aufeinander schwenkbar sind.

6. Vakuumaufdampfeinrichtung nach einem der vorhergehenden Ansprüche, **dadurch gekennzeichnet**, daß der zweite Teil (14) bezüglich des ersten Teiles (12) verschiebbar gelagert ist (Fig. 4).

7. Vakuumaufdampfeinrichtung nach Anspruch 6 **gekennzeichnet durch** zwei Antriebsvorrichtungen (60'a, 60'b) zum unabhängigen Verschieben des zweiten Teiles (14) bezüglich des ersten (12) in zwei sich kreuzenden Richtungen (Fig. 4).

8. Vakuumaufdampfeinrichtung nach Anspruch 5 oder 7, **gekennzeichnet durch** zwei Antriebsmotoren (62), deren Drehzahl unabhängig voneinander steuerbar ist.

FIG. 1

40

58

64

62

60a

58b

14

16

42

52

64

62

60b

58c

58a

58b

III

58c

FIG. 2

FIG. 3

FIG. 4